# EUROPÄISCHE PATENTSCHRIFT

(11) **EP 0 392 312 B1**
(45) Veröffentlichungstag und Bekanntmachung des Hinweises auf die Patenterteilung: **22.06.1994**
(21) Anmeldenummer: 90106296.8
(22) Anmeldetag: 02.04.1990
(51) Int. Cl.: H04R 25/00, H03G 3/20, H03F 1/02

(54) **Endverstärker für Hörgeräte**
Amplifier for hearing aid
Amplificateur pour appareil de correction auditive

(30) Priorität: 14.04.1989 EP 89106659
(43) Veröffentlichungstag der Anmeldung: 17.10.1990
(73) Patentinhaber: Siemens Audiologische Technik GmbH, 91058 Erlangen (DE)
(72) Erfinder: Wagner, Jürgen, Dipl.-Ing. (FH), D-8643 Küps (DE)
(74) Vertreter: Fuchs, Franz-Josef, Dr.-Ing.

(56) Entgegenhaltungen:
- GB-A- 1 161 002
- US-A- 4 068 090

## Beschreibung

Die Erfindung bezieht sich auf einen Endverstärker für Hörgeräte mit einstellbarer Ausgangspegelbegrenzung, dessen Ausgang mit einer Betriebsspannungsquelle über einen einstellbaren Ausgangsspannungsteiler verbunden ist.

Im Fachhandel, z.B. bei Hörgeräte-Akustikern, werden Hörgeräte mit einem Endverstärker der eingangs genannten Art angeboten. Bei diesen bekannten Endverstärkern ist der Ausgang über einen Hörer mit der Betriebsspannungsquelle verbunden. Zu dem Hörer ist eine Reihenschaltung, bestehend aus einem Steiler, einem Ladekondensator und zwei antiparallel geschalteten Dioden (Schottky-Doppeldiode), parallelgeschaltet. Eine derartige Schaltung erlaubt eine Absenkung des Ausgangspegels der Endstufe in der Größenordnung von etwa 10 dB, was die Anpaßbarkeit des Hörgerätes an das geschädigte Ohr hinsichtlich des richtigen Ausgangspegels auf diesen Anpassungsbereich einschränkt. Nachteilig ist auch der wegen seiner erforderlichen Größe viel Platz beanspruchende Ladekondensator. Außerdem wird trotz Pegelabsenkung keine Reduzierung des Stromverbrauchs des Endverstärkers erreicht.

Der Erfindung liegt die Aufgabe zugrunde, bei einem Endverstärker für Hörgeräte eine einstellbare Ausgangs-Pegelbegrenzung zu schaffen, die sich durch geringeren Platzbedarf, größere Ausgangspegelreduzierung und verminderte Stromaufnahme auszeichnet.

Diese Aufgabe wird bei dem erfindungsgemäßen Endverstärker für Hörgeräte nach Patentanspruch 1 gelöst. Dazu ist der einstellbare Ausgangsspannungsteiler aus einer Reihenschaltung eines Hörers mit einem als Zweipol geschalteten Steller-Widerstand zur Ausgangspegelbegrenzung gebildet und von einem für A-Betrieb eingestellten Ruhestrom durchflossen, welcher eine von der Ausgangspegeleinstellung abhängige Spannungsänderung erzeugt, die an einem Anschluß des Ausgangsspannungsteilers abgegriffen und dem Eingang des Endverstärkers als eine von der eingestellten Pegelbegrenzung abhängige Gegenspannung über einen ersten Widerstand zugeführt wird, der mit einem zweiten Widerstand einen hochohmigen Spannungsteiler bildet.

Die mit der Erfindung erzielbaren Vorteile bestehen insbesondere darin, daß bei Fortfall einer Doppeldiode und eines besonders platzgreifenden Ladekondensators lediglich zwei Widerstände erforderlich sind, die schon in diskreter Technik und insbesondere in heute üblicher Hybridtechnik deutlich weniger Platz beanspruchen. Darüber hinaus wird durch die erfindungsgemäß erzielte Anpassung des Arbeitspunktes des Endverstärkers an veränderte Betriebsbedingungen durch Verändern der Einstellung des Stellerwiderstandes zur Ausgangspegeleinstellung ein erheblich größerer linearer Aussteuerbereich auch bei reduziertem Ausgangspegel erschlossen, wobei der nutzbare Einstellbereich der Pegelreduzierung deutlich größer als bei bekannten Schaltungen ist. Durch die Arbeitspunktanpassung wird zugleich eine Reduzierung der Ruhestromaufnahme des Endverstärkers bei abgesenktem Ausgangspegel bewirkt. Außerdem wird eine unerwünschte Wechselspannungsgegenkopplung weitgehend vermieden.

Weitere Vorteile und Einzelheiten der Erfindung ergeben sich aus der nachfolgenden Beschreibung von Ausführungsbeispielen anhand der Zeichnungen und in Verbindung mit den Unteransprüchen.

Es zeigen:
Figur 1 ein vereinfachtes Schaltschema eines erfindungsgemäßen Endverstärkers für Hörgeräte,
Figur 2 ein vereinfachtes Schaltschema einer Variante eines erfindungsgemäßen Endverstärkers,
Figur 3 ein vereinfachtes Schaltschema einer weiteren Variante eines erfindungsgemäßen Endverstärkers und
Figur 4 ein vereinfachtes Schaltschema einer weiteren Variante eines erfindungsgemäßen Endverstärkers mit angekoppeltem Vorverstärker.

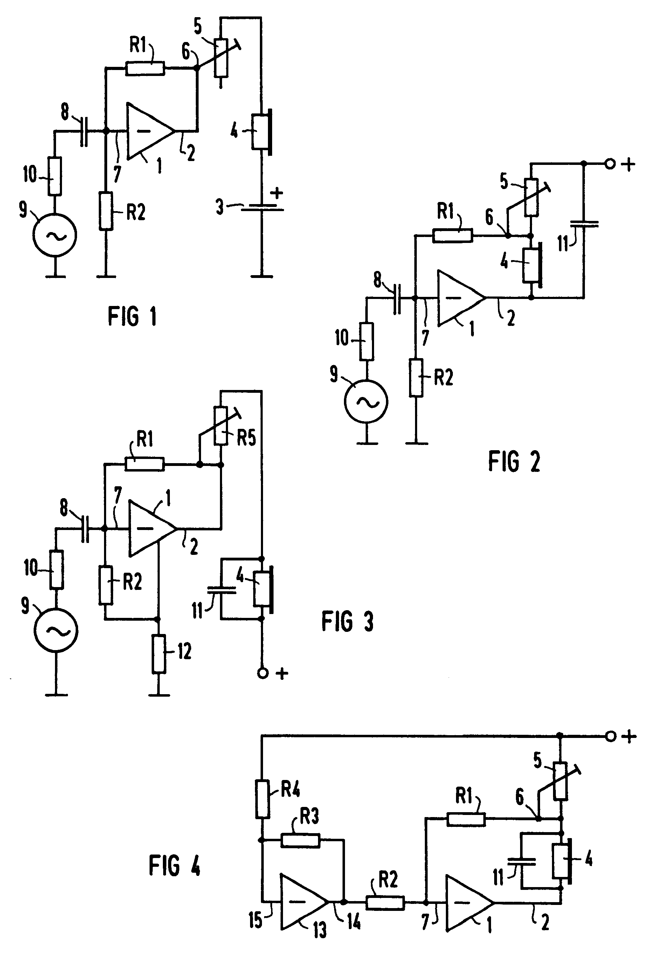

Der Endverstärker 1 gemäß Figur 1 kann sowohl als diskreter Verstärker oder als integrierter Schaltkreis ein- oder mehrstufig aufgebaut sein. Der Ausgang 2 des Endverstärkers 1 ist mit der Betriebsspannungsquelle 3 über einen einstellbaren Ausgangsspannungsteiler verbunden, der aus einer Reihenschaltung eines Hörers 4 mit einem als Zweipol geschalteten Stellerwiderstand 5 besteht. Der dem Ausgang 2 des Endverstärkers 1 zunächst liegende Anschluß 6 des Stellerwiderstandes 5 ist mit dem Eingang 7 des Endverstärkers 1 über einen ersten Widerstand R1 verbunden, der mit einem zweiten Widerstand R2 einen Eingangsspannungsteiler am Eingang 7 des Endverstärkers 1 bildet.

Die Wirkungsweise dieses Endverstärkers für Hörgeräte mit einstellbarer Ausgangspegelbegrenzung ist folgende.

In Abhängigkeit von der Einstellung des Stellerwiderstandes 5 wird über den Widerstand R1, der mit dem Widerstand R2 einen hochohmigen Spannungsteiler am Eingang des Endverstärkers bildet, eine Verschiebung des Arbeitspunktes des Endverstärkers erreicht, derart, daß bei Übersteuerung des Endverstärkers eine möglichst symmetrische Begrenzung der Spitzen des Nutzsignales erfolgt. Daher bewirkt die erfindungsgemäße Schaltung bei Absenkung des Ausgangspegels mittels des Stellerwiderstandes 5 zugleich eine Verschiebung des Arbeitspunktes des Endverstärkers 1 in einen mittleren Bereich der jeweiligen, durch die Pegelabsenkung gewählten Arbeitskennlinie des Endverstärkers. Da Verstärker, die im A-Betrieb arbeiten, prinzipiell einen konstanten Ruhestrom haben müssen, eignen sich für den erfindungsgemäßen Endverstärker insbesondere solche Endverstärker, die einen Konstantstromausgang haben, was vor allem in integrierten Schaltungen besonders günstig bei geringem Platzbedarf realisierbar ist.

Soweit insbesondere integrierte Endverstärkerschaltungen bereits eine vorgegebene Arbeitspunkteinstellung für A-Betrieb haben, wird diese mit der erfindungsgemäßen Schaltung in der zuvor beschriebenen Weise verändert, wobei der aus den Widerständen R1 und R2 bestehende Eingangsspannungsteiler so bemessen ist, daß sich bei maximalem Ausgangspegel (der Stellerwiderstand 5 hat einen Wert von 0 Ohm) am mit dem Eingang 7 verbundenen Spannungsteilerpunkt eine Spannung einstellt, die wenigstens annähernd der voreingestellten Eingangsspannung entspricht. Dabei braucht der voreingestellte Arbeitspunkt eines Klasse A Verstärkers für den maximalen Ausgangspegel nicht verändert zu werden. Da die Pegelabsenkung am Ausgang durch den Stellerwiderstand 5 über den hochohmigen Spannungsteiler R1 und R2 durch die Arbeitspunktveränderung auch eine Absenkung des Ruhestromes bewirkt, ist die bei Hörgeräten regelmäßig aus einer 1,3 VoltBatterie bestehende Spannungsquelle demzufolge geringer belastet, was zu einer Erhöhung der Gebrauchsdauer führt.

Das Nutzsignal kann dem Endverstärker 1 über einen Kondensator 8 aus einem Generator 9 mit einem Generatorinnenwiderstand 10 zugeführt werden, die durch einen Vorverstärker realisierbar sind. Zweckmäßigerweise soll der Generator 9 einen niedrigen Generatorinnenwiderstand 10 aufweisen, wodurch ein bei Pegelabsenkung am Endverstärker eintretender Verstärkungsverlust kompensiert wird.

Die Schaltungsvariante einer erfindungsgemäßen Endstufe nach Figur 2 unterscheidet sich von dem Ausführungsbeispiel in Figur 1, abgesehen von der nicht dargestellten Betriebsspannungsquelle 3, zunächst durch eine veränderte Reihenfolge der Bauteile im Ausgangsspannungsteiler. Der Hörer 4 ist dem Ausgang 2 des Endverstärkers 1 zunächst liegend angeordnet und der als Zweipol geschaltete Steller-Widerstand 5 ist mit der Betriebsspannung verbunden. Zusätzlich ist ein Kondensator 11 vorhanden, der den Ausgangsspannungsteiler überbrückt. Während bei bekannten Hörgeräten der Hörer mit einem zugehörigen Kondensator überbrückt wird, um das Übertragungsverhalten des Hörers zu beeinflussen, wird nach der Erfindung mit dem Kondensator 11 nicht nur das Übertragungsverhalten des Hörers beeinflußt, sondern auch durch die Ausgangspegelbegrenzung entstehende Oberwellen des Nutzsignals über den Kondensator 11 abgeleitet, der zu diesem Zweck auch unmittelbar nur den Hörer überbrücken kann. Der bekannte Kondensator wird daher für einen zusätzlichen Zweck mitbenutzt.

Die dem Eingang 7 über den hochohmigen Spannungsteiler R1 und R2 zugeführte Gegenspannung braucht nicht zwingend am Anschlußpunkt 6 des Steller-Widerstandes bzw. des Ausgangsspannungsteilers abgenommen zu werden, sondern kann auch am Ausgang 2 des Endverstärkers abgenommen werden, an welchem der Ausgangsspannungsteiler angeschlossen ist. Es sind dann lediglich die beiden Widerstände R1 und R2 des hochohmigen Spannungsteilers den Spannungsverhältnissen am jeweiligen Anschlußpunkt des Ausgangsspannungsteilers anzupassen, um eine in Abhängigkeit von der am Steller-Widerstand 5 eingestellten Pegelreduzierung erfolgende Arbeitspunktverschiebung des Endverstärkers zu bewirken. In der dargetellten Schaltung haben die Widerstände R1 und R2 gleiche Werte. Der Widerstand R2 kann entfallen und durch den Eingangswiderstand realisiert werden, wenn R1 entsprechend angepaßt wird.

In Figur 3 ist eine weitere Variante eines erfindungsgemäßen Endverstärkers mit einstellbarer Ausgangspegelbegrenzung dargestellt. Im Gegensatz zu der aus Figur 1 bekannten Schaltung ist der zum hochohmigen Spannungsteiler gehörende zweite Widerstand R2 mit einem sehr kleinen Emitterwiderstand 12 verbunden. Ein solcher Emitterwiderstand ist regelmäßig auch in integrierten Schaltkreisen vorhanden und zugänglich. Durch eine derartige Beschaltung ist es möglich, insbesondere durch eventuelle Herstellungstoleranzen der Widerstände R1 und R2 im hochohmigen Spannungsteiler bedingte Abweichungen von den errechneten Spannungsteilerwerten auszugleichen, indem der Widerstand R2 entweder mit dem Emitterwiderstand 12 oder mit Masse verbunden wird, wodurch eine geringfügige Spannungsänderung am Eingang 7 des Endverstärkers 2 entsteht, mit entsprechender Arbeitspunktverschiebung auf den gewünschten und berechneten Wert. Es kann somit ein anderer Abgleich des hochohmigen Spannungsteilers entfallen. Der bereits aus Figur 2 bekannte und in seiner Funktion erläuterte Kondensator 11 überbrückt in diesem Ausführungsbeispiel den Hörer 4.

Eine besonders vorteilhafte Variante der erfindungsgemäßen Endstufe mit einstellbarer Ausgangspegelbegrenzung ist in Figur 4 dargestellt. Zur Übersichtlichkeit wurde die bisher verwendete und übereinstimmende Kennzeichnung für funktionsgleiche Bauteile beibehalten.

Anstelle des beschriebenen Generators 9 mit dem Generatorinnenwiderstand 10 zur Speisung des Endverstärkers ist gemäß Figur 4 ein Vorverstärker 13 schematisch dargestellt, der einen Ausgang 14 mit niedrigem Innenwiderstand hat und über den zweiten Widerstand R2 des Eingangsspannungsteilers an den Endverstärker 1 angekoppelt ist. Damit entfällt auch der Koppelkondensator 8 und wird durch den ohnehin erforderlichen Widerstand R2 des hochohmigen Spannungsteilers ersetzt. Der Ausgang 14 und der Eingang 15 des Vorverstärkers 13 sind über einen dritten Widerstand R3 überbrückt, welcher am Eingang 15 des Vorverstärkers 13 über einen vierten Widerstand R4 mit der nicht dargestellten Betriebsspannungsquelle 3 verbunden ist.

Durch diese Ankopplung des Endverstärkers mit einstellbarer Ausgangspegelbegrenzung an den Vorverstärker können neben der Bauteileersparnis (Wegfall des Koppelkondensators) auch noch verbrauchs- und typbedingte Schwankungen der regelmäßig aus einer Batterie von 1,3 Volt bestehenden Betriebsspannungsquelle ausgeglichen werden, insbesondere, wenn sich die Werte des ersten und des zweiten Widerstandes R1 und R2 so zueinander verhalten, wie sich die Werte des dritten und vierten Widerstandes R3 und R4 am Vorverstärker 13 zueinander verhalten, wobei der Wert des dritten Widerstandes R3 deutlich größer ist, vorzugsweise etwa das Zehnfache des Wertes vom vierten Widerstand R4 beträgt. Eine derartige Schaltung hat bei vollem Ausgangspegel keinen Temperaturgang und kann durch einen handelsüblichen integrierten Schaltkreis realisiert werden, z.B. vom Typ LC 508, hergstellt von der Firma GENNUM, Burlington, Ontario, Kanada, der insgesamt drei unabhängige Verstärkereinheiten enthält, von denen eine in der beschriebenen Weise als Endverstärker und eine zweite als Vorverstärker benutzt werden kann.

## Patentansprüche

1. Endverstärker für Hörgeräte mit einstellbarer Ausgangspegelbegrenzung, dessen Ausgang (2) mit einer Betriebsspannungsquelle (3) über einen einstellbaren Ausgangsspannungsteiler verbunden ist,
**dadurch gekennzeichnet,**
daß der Ausgangsspannungsteiler aus einer Reihenschaltung eines Hörers (4) mit einem als Zweipol geschalteten Steller-Widerstand (5) zur Ausgangspegelbegrenzung gebildet und von einem für A-Betrieb eingestellten Ruhestrom durchflossen ist, welcher eine von der Ausgangspegeleinstellung abhängige Spannungsänderung erzeugt, die an einem Anschluß (2, 6) des Ausgangsspannungsteilers abgegriffen und dem Eingang (7) des Endverstärkers (1) als eine von der eingestellten Pegelbegrenzung abhängige Gegenspannung über einen ersten Widerstand (R1) zugeführt wird, der mit einem zweiten Widerstand (R2) einen hochohmigen Spannungsteiler bildet.

2. Endverstärker nach Anspruch 1, bei dem der zweite Widerstand (R2) des hochohmigen Spannungsteilers mit Masse verbunden ist.

3. Endverstärker nach Anspruch 1, bei dem der zweite Widerstand (R2) des hochohmigen Spannungsteilers über einen sehr kleinen Emitterwiderstand (12) des Endverstärkers (1) mit Masse verbunden ist.

4. Endverstärker nach Anspruch 1, bei dem der zweite Widerstand (R2) des hochohmigen Spannungsteilers durch den Eingangswiderstand des Endverstärkers (1) gebildet ist.

5. Endverstärker nach einem der Ansprüche 1 bis 3, bei dem beide Widerstände (R1, R2) des hochohmigen Spannungsteilers wenigstens annähernd gleiche Werte haben.

6. Endverstärker nach einem der Ansprüche 1 bis 5, bei dem ein Widerstand (R1, R2) des hochohmigen Spannungsteilers abgleichbar ist.

7. Endverstärker nach einem der Ansprüche 1 bis 6, bei dem der erste Widerstand (R1) des hochohmigen Spannungsteilers mit dem dem Ausgang (2) des Endverstärkers (1) zunächst liegenden Anschluß (2, 6) des Ausgangsspannungsteilers verbunden ist.

8. Endverstärker nach einem der Ansprüche 1 bis 7, bei dem der Ausgangsspannungsteiler oder der Hörer (4) mit einem Kondensator (11) überbrückt und der Hörer (4) wahlweise der Betriebsspannungsquelle (3) oder dem Ausgang (2) des Endverstärkers (1) zunächst liegend angeordnet ist.

9. Endverstärker nach Anspruch 1 oder nach einem der Ansprüche 6 bis 8, welcher einen Konstantstromausgang hat und Bestandteil einer integrierten Schaltung ist, die einen Vorverstärker (13) mit einem Ausgang (14) aufweist, der über den zweiten Widerstand (R2) des hochohmigen Spannungsteilers an den Endverstärker (1) angekoppelt ist, wobei Ausgang (14) und Eingang (15) des Vorverstärkers (13) über einen dritten Widerstand (R3) überbrückt sind, welcher am Eingang (15) des Vorverstärkers (13) über einen vierten Widerstand (R4) mit der Betriebsspannungsquelle (3) verbunden ist.

10. Endverstärker nach Anspruch 9, bei dem sich die Werte des ersten und des zweiten Widerstandes (R1, R2) so zueinander verhalten, wie sich die Werte des dritten und vierten Widerstandes (R3, R4) am Vorverstärker (13) zueinander verhalten, wobei der Wert des dritten Widerstandes (R3) deutlich größer ist, vorzugsweise etwa das Zehnfache des Wertes vom vierten Widerstand (R4) beträgt.

## Claims

1. Output amplifier for hearing devices with adjustable output level limitation, the output (2) of which is connected to an operating voltage source (3) by way of an adjustable output voltage divider, characterized in that the output voltage divider is formed from a series connection of an earphone (4) with an actuator resistance (5), connected as a two-terminal network, to the output level limitation and has a quiescent current set for A-operation flowing through it, the current generating a voltage change dependent on the output level setting, which change is picked up at a terminal (2, 6) of the output voltage divider and is supplied to the input (7) of the output amplifier (1) as a countervoltage dependent on the set level limitation by way of a first resistance (R1), which forms with a second resistance (R2) a high-resistance voltage divider.

2. Output amplifier according to claim 1, where the second resistance (R2) of the high-resistance voltage divider is connected to earth.

3. Output amplifier according to claim 1, where the second resistance (R2) of the high-resistance voltage divider is connected to earth by way of a very small emitter resistance (12) of the output amplifier (1).

4. Output amplifier according to claim 1, where the second resistance (R2) of the high-resistance voltage divider is formed by the input resistance of the output amplifier (1).

5. Output amplifier according to one of claims 1 to 3, where both resistances (R1, R2) of the high-resistance voltage divider have at least approximately the same values.

6. Output amplifier according to one of claims 1 to 5, where a resistance (R1, R2) of the high-resistance voltage divider can be adjusted.

7. Output amplifier according to one of claims 1 to 6, where the first resistance (R1) of the high-resistance voltage divider is connected to the terminal (2, 6) of the output voltage divider lying next to the output (2) of the output amplifier (1).

8. Output amplifier according to one of claims 1 to 7, where the output voltage divider or the earphone (4) is short-circuited with a capacitor (11) and the earphone (4) is arranged to lie either next to the operating voltage source (3) or the output (2) of the output amplifier (1).

9. Output amplifier according to claim 1 or according to one of claims 6 to 8, having a constant current output and being a component part of an integrated circuit, which has a pre-amplifier (13) with an output (14), which is coupled by way of the second resistance (R2) of the high-resistance voltage divider to the output amplifier (1), with the output (14) and the input (15) of the pre-amplifier (13) being short-circuited by way of a third resistance (R3), which is connected at the input (15) of the pre-amplifier (13) by way of a fourth resistance (R4) to the operating voltage source (3).

10. Output amplifier according to claim 9, where the values of the first and the second resistance (R1, R2) are to one another as the values of the third and fourth resistance (R3, R4) on the pre-amplifier (13) are to one another, with the value of the third resistance (R3) being clearly greater, preferably amounting to about ten times the value of the fourth resistance (R4).

## Revendications

1. Amplificateur terminal pour des appareils auditifs avec limitation réglable du niveau de sortie, dont la sortie (2) est reliée à une source de tension de service (3), par l'intermédiaire d'un diviseur de tension de sortie réglable,
caractérisé en ce que le diviseur de tension de sortie est formé par un circuit-série constitué d'un écouteur (4) et d'une résistance de réglage (5), montée en tant que dipôle, pour la limitation du niveau de sortie, et est traversé par un courant de repos réglé pour un fonctionnement-A, courant qui crée une modification de tension qui est dépendante du réglage du niveau de sortie, qui est prélevée à une borne (2, 6) du diviseur de tension de sortie et qui est envoyée à l'entrée (7) de l'amplificateur terminal (1), en tant que tension antagoniste qui dépend de la limitation réglée du niveau, par l'intermédiaire d'une première résistance (R1) qui forme, avec une deuxième résistance (R2), un diviseur de tension à forte valeur ohmique.

2. Amplificateur terminal suivant la revendication 1, dans lequel la deuxième résistance (R2) du diviseur de tension à forte valeur ohmique est reliée à la masse.

3. Amplificateur terminal suivant la revendication 1, dans lequel la deuxième résistance (R2) du diviseur de tension à forte valeur ohmique est reliée à la masse, par l'intermédiaire d'une résistance d'émetteur (12), très faible, de l'amplificateur terminal (1).

4. Amplificateur terminal suivant la revendication 1, dans lequel la deuxième résistance (R2) du diviseur de tension à forte valeur ohmique est formée par la résistance d'entrée de l'amplificateur terminal (1).

5. Amplificateur terminal suivant l'une des revendications 1 à 3, dans lequel les deux résistances (R1, R2) du diviseur de tension à forte valeur ohmique ont des valeurs au moins approximativement égales.

6. Amplificateur terminal suivant l'une des revendications 1 à 5, dans lequel une résistance (R1, R2) du diviseur de tension à forte valeur ohmique est réglable.

7. Amplificateur terminal suivant l'une des revendications 1 à 6, dans lequel la première résistance (R1) du diviseur de tension à forte valeur ohmique est reliée à la borne (2, 6) du diviseur de tension de sortie s'appliquant en premier lieu à la sortie (2) de l'amplificateur terminal (1).

8. Amplificateur terminal suivant l'une des revendications de 1 à 7, dans lequel le diviseur de tension de sortie ou l'écouteur (4) est shunté par un condensateur (11) et l'écouteur (4) est monté, en étant appliqué en premier lieu, au choix, sur la source de tension de service (3) ou sur la sortie (2) de l'amplificateur terminal (1).

9. Amplificateur terminal suivant la revendication 1 ou suivant l'une des revendications 6 à 8, qui comporte une sortie à courant constant et qui est un élément constitutif d'un circuit intégré qui comporte un préamplificateur (13) ayant une sortie (14) qui est couplée, par l'intermédiaire de la deuxième résistance (R2) du diviseur de tension à forte valeur ohmique, à l'amplificateur terminal (1), la sortie (14) et l'entrée (15) du préamplificateur (13) étant shuntés par l'intermédiaire d'une troisième résistance (R3) qui est reliée, au niveau de l'entrée (15) du préamplificateur (13), à la source de tension de service (3) par l'intermédiaire d'une quatrième résistance (R4).

10. Amplificateur terminal suivant la revendication 9, dans lequel les valeurs des première et deuxième résistances (R1, R2) se comportent l'une par rapport à l'autre de la même manière que se comportent les valeurs des troisième et quatrième résistances (R3, R4) au niveau du préamplificateur (13), la valeur de la troisième résistance (R3) étant nettement supérieure, et de préférence d'une puissance de 10, à la valeur de la quatrième résistance (R4).
